# EUROPÄISCHE PATENTSCHRIFT

(11) **EP 0 865 081 B1**
(45) Veröffentlichungstag und Bekanntmachung des Hinweises auf die Patenterteilung: **14.03.2007**
(21) Anmeldenummer: 98102580.2
(22) Anmeldetag: 14.02.1998
(51) Int. Cl.: H01L 21/60, H01L 21/304, H01L 23/485

(54) **Verfahren zum Herstellen von elektronischen Elementen**
Process for fabricating electronic elements
Procédé de fabrication d'éléments électroniques

(30) Priorität: 27.02.1997 DE 19707887
(43) Veröffentlichungstag der Anmeldung: 16.09.1998
(73) Patentinhaber: Micronas GmbH, 79108 Freiburg i. Br. (DE)
(72) Erfinder: Igel, Günter, Dipl.-Ing., 79331 Teningen (DE); Mall, Martin, Dr. Dipl.-Phys., 79100 Freiburg (DE)
(74) Vertreter: Göhring, Robert

(56) Entgegenhaltungen:
- EP-A- 0 573 724
- WO-A-90/15438
- US-A- 3 639 811
- US-A- 3 747 202
- US-A- 4 503 597

## Beschreibung

Die Erfindung betrifft ein Verfahren zum Herstellen von elektronischen Elementen gemäß Oberbegriff des Anspruchs 1.

Ein derartiges Verfahren ist aus der EP 0 573 724 A1 bekannt.

Ein weiteres solches Verfahren ist aus der US 3 639 811 bekannt. Bei diesem Verfahren wird in den Trennbereichen zwischen den elektronischen Elementen eine Sägespur erzeugt, die sich bis zu der Kontaktschicht erstreckt. Die Kontaktschicht ist so gewählt, daß sie auf dem Kontaktpad haftet und auf der Oberfläche des mit einer Isolatorschicht versehenen Halbleiterchips nicht haftet. Dann werden die elektronischen Elemente durch Anwenden von mechanischem Druck voneinander getrennt. Dabei lösen sich die Kontaktanschlüsse von den gegenüberliegenden elektronischen Elementen, so daß sie von dem elektronischen Element, an dessen Kontaktpad sie befestigt sind, abstehen.

Aus der DE 40 20 195 ist ein Verfahren bekannt, bei dem auf einem Halbleiterwafer elektronische Elemente, die aktive Bereiche aufweisen, ausgebildet werden, zwischen denen Trennbereiche zum Trennen der elektronischen Elemente vorgesehen sind. Durch Ausbilden einer Sägespur werden die Trennbereiche strukturiert. Sie weisen eine Vertiefung auf. Das Trennen der elektronischen Elemente erfolgt durch Sägen entlang der Sägelinien.

Aus der DE 43 17 721 ist ein Verfahren bekannt, bei dem die Trennbereiche zwischen den elektronischen Elementen durch Ätzen strukturiert werden. Bei diesem Verfahren wird ein SOI (Silicon On Insulator) Substrat verwendet. Die elektronischen Elemente werden durch Wegätzen der Isolatorschicht vereinzelt.

Nachdem die elektronischen Elemente aus dem Halbleiterwafer herausgetrennt worden sind, müssen sie mit externen Anordnungen, wie Leiterrahmen (lead frames) und/oder Lötplatinen, in Kontakt gebracht werden. Die hierzu erforderlichen Kontaktanschlüsse befinden sich auf der Oberfläche der elektronischen Elemente. Zum elektrischen Kontaktieren werden die elektronischen Elemente durch Bondverfahren oder durch eine Flip-Chip-Technologie mit der externen Anordnung verbunden. Beide Verfahren sind aufwendig und mit verschiedenen Nachteilen verbunden. So entstehen beispielsweise durch das Kontaktieren große mechanische Spannungen in den elektronischen Elementen. Die elektronischen Elemente müssen eine Mindesthöhe aufweisen, um der mechanischen Belastbarkeit bei dem Montage- bzw. Kontaktiervorgang standzuhalten. Separate Kontaktanschlüsse (Bondpads) müssen angeordnet werden, um die elektronischen Elemente zu kontaktieren. Dazu kommen nur wenige Materialien in Betracht. Die Flip-Chip-Technologie hat den Nachteil, daß die elektronischen Elemente nicht immer als Sensoren geeignet sind, da ihre Oberfläche für die Sensorsignalgewinnung schwer zugänglich ist. Auch ist das Bearbeiten der einzelnen elektronischen Elemente nach dem Trennen aus dem Halbleiterwafer problematisch.

Der Erfindung liegt die Aufgabe zugrunde, ein gattungsgemäßes Verfahren zu schaffen, bei dem die obengenannten Nachteile beseitigt sind.

Diese Aufgabe wird durch ein Verfahren mit den Merkmalen des Anspruchs 1 gelöst.

Bei dem erfindungsgemäßen Verfahren ist ein einziger Vorgang zum Abtragen von Material des Halbleiterwafers erforderlich, bei dem die Kontaktanschlüsse freigelegt werden. Durch das Freilegen der Kontaktanschlüsse werden diese und die einander gegenüberliegenden elektronischen Elemente gleichzeitig voneinander getrennt. Es treten die Toleranzprobleme, die bei einem Sägeprozeß und einem getrennten Verfahren zum Ablösen der Kontaktanschlüsse durch Druckausüben erforderlich sind, nicht auf. Die Form der Kontaktanschlüsse wird durch die Struktur der Trennbereiche auf der Vorderseite des Halbleiterwafers bestimmt. Somit kann die Form der Kontakte durch diese Struktur bestimmt und entsprechend unterschiedlich gewählt werden. Dies ist gerade dadurch möglich, daß das Material in den Trennbereich abgetragen wird und dadurch die Kontaktanschlüsse freigelegt werden. Diese Kontaktanschlüsse können weiterbearbeitet werden. Sie können beispielsweise gebogen werden und sind zudem relativ stabil. Zudem können identische Chips hergestellt werden, da sich die Kontaktanschlüsse höchstens bis zu dem benachbarten elektronischen Element erstrecken und dieses somit nicht überlappen. Bei geeigneter Wahl der Länge der Kontaktanschlüsse, die durch die Struktur in dem Trennbereich bestimmt wird, können identische elektronische Elemente mit identischen Kontaktanschlüssen einander gegenüber liegen.

Mit dem erfindungsgemäßen Verfahren werden elektronische Elemente mit leitfähigen Kontaktanschlüssen, die von der Vorderseite der elektronischen Elemente entlang deren Seitenflächen verlaufen und freiliegende Enden aufweisen, hergestellt. Mit diesen Kontaktanschlüssen kann das jeweilige elektronische Element leicht mit einer externen Anordnung verbunden werden. Da die Kontaktanschlüsse unabhängig von den Leiterbahnen auf den elektronischen Elementen hergestellt werden können, kann ihre Dicke unabhängig von den Anforderungen an die Leiterbahnen gewählt werden, so daß die Dicke für die Kontaktierung geeignet festgelegt werden kann.

Gleichzeitig mit dem Abtragen des Materials in den Trennbereichen wird Material der Rückseite des Halbleiterwafers abgetragen. Die Kontaktanschlüsse stehen auf der Rückseite des elektronischen Elements über. Sie können unterschiedlich ausgebildet sein. Beispielsweise können sie als Beinchen, auf denen das elektronische Element stabil steht, verwendet werden.

Bevorzugterweise erfolgt das Abtragen von Material des Halbleiterwafers durch Ätzen. Wenn der Halbleiterwafer von der Rückseite ausgehend geätzt wird, können die Kontaktanschlüsse ohne Beschädigung freigelegt werden. Abhängig von der Struktur der Trennbereiche kann auf die Rückseite des Halbleiterwafers eine Verzögerungsschicht aufgebracht werden, die eine niedrigere Abtragrate bzw. Ätzrate als das Material des Halbleiterwafers aufweist. In dieser Verzögerungsschicht werden in den Bereichen, in denen das Material des Halbleiterwafers stärker abgetragen werden soll, Durchbrechungen ausgebildet. Diese liegen üblicherweise in den Trennbereichen. Dicke und Verzögerungsrate der Verzögerungsschicht werden entsprechend der gewünschten Enddicke der elektronischen Elemente und der Dicke des in den Trennbereichen zu entfernenden Materials und dessen Abtragsrate gewählt.

Gemäß einem weiteren Ausführungsbeispiel der Erfindung kann das Abtragen des Materials des Halbleiterwafers mit einer Geschwindigkeit erfolgen, die entlang der Rückseite der elektronischen Elemente wenigstens einen Gradienten aufweist, so daß die Rückseite der elektronischen Elemente gegenüber ihrer Vorderseite geneigt ist. Dies ist bei der Anwendung der elektronischen Elemente für Sensoren besonders vorteilhaft, da die Sensor-Rückseite üblicherweise parallel zu einer Ebene liegt, in der sich die Montageplattform befindet, und somit die Sensorfläche gegenüber der Montageplattform geneigt angebracht werden kann.

Die leitfähige Kontaktschicht kann ein elektrisch-, thermisch- bzw. lichtleitendes Material umfassen. Entsprechend werden die leitfähigen Kontaktanschlüsse für eine elektrische Kontaktverbindung, Wärmeableitung oder zum Anschluß eines Lichtleiters oder einer Kombination von verschiedenen Kontaktanschlüssen verwendet. Bei elektrischen Kontaktanschlüssen kann das Kontaktieren durch Kleben, Pressen, Löten oder ähnliche Verfahren erfolgen. Es ist somit kein herkömmliches Bond- oder Flip-Chip-Verfahren erforderlich. Die elektronischen Elemente können sehr dünn hergestellt werden, da sie keinen großen mechanischen Belastungen beim Kontaktieren ausgesetzt sind. Es sind keine seperaten Kontaktanschlüsse auf den elektronischen Elementen erfoderlich, da die auf der Vorderseite verlaufenden Kontaktanschlüsse von einem ohnehin zu kontaktierenden Bereich oder einer Leiterbahn ausgehen können. Es bestehen keine Einschränkungen für die Kontaktmaterialien, wie sie sich sonst bei herkömmlichen Kontaktierverfahren ergeben. Auch müssen keine Bonddrähte verwendet werden. Der Querschnitt der Kontaktanschlüsse und der Kontaktzuleitung kann für die entsprechende Anwendung geeignet gewählt werden, ohne daß diese durch das Kontaktierverfahren eingeschränkt wird. Auch ist die Vorderseite der elektronischen Elemente frei zugänglich, so daß dort Sensorflächen aufgebracht werden können, und somit für die Sensorsignalgewinnung sehr geeignet sind. Die leitfähige Kontaktschicht kann verschiedene, aufeinanderfolgende Schichten umfassen.

Vorteilhafterweise können die freigelegten Kontaktanschlüsse thermisch, chemisch bzw. mechanisch bearbeitet werden. Ein Beispiel für eine thermische Bearbeitung wäre die Bearbeitung mit einem Laser. Dadurch könnte ein einstückiger Kontakt, der zu zwei benachbarten elektronischen Elementen gehört, durchtrennt werden. Es kann auch das Ende des Kontaktanschlusses mit einem Laser erhitzt werden, was zu der Ausbildung eines tropfenförmigen Kontaktanschlußendes führt. Es kann in diesem Fall leichter kontaktiert werden. Die freigelegten Kontaktanschlüsse können verstärkt, insbesondere galvanisch verstärkt werden. Dies führt zu einer Erhöhung der Stabilität der Kontaktanschlüsse, so daß diese stärker belastet werden können. Die freigelegten Kontaktanschlüsse können anschließend bearbeitet, beispielsweise gebogen werden.

Gemäß einem bevorzugten Ausführungsbeispiel der Erfindung können die aktiven Bereiche mittels der leitfähigen Kontaktschicht kontaktiert werden, wobei die Kontaktschicht auf eine auf der Vorderseite des Halbleiterwafers ausgebildeten Isolatorschicht mit Öffnungen zum Kontaktieren der aktiven Bereiche aufgebracht und strukturiert wird. Dies ist insbesondere bei einer elektrisch leitfähigen Kontaktschicht vorteilhaft, da dann die leitfähigen, von dem elektronischen Element nach außen gehenden Kontaktanschlüsse gleichzeitig mit dem Aufbringen und Strukturieren der zum Kontaktieren der aktiven Bereiche des elektronischen Elements erforderlichen Schicht hergestellt werden können. Benachbarte Kontaktanschlüsse können während der Strukturierung der Kontaktschicht voneinander getrennt werden.

Vorteilhafterweise umfaßt die räumliche Struktur der Trennbereiche eine Vertiefung entlang des Querschnitts. Die Form der Vertiefung kann jeweils geeignet hinsichtlich der gewünschten Form der Kontaktanschlüsse und deren Länge gewählt werden. Wenn in den Trennbereichen eine Vertiefung ausgebildet ist, kann diese wenigstens eine Erhöhung aufweisen. Dadurch wird es ermöglicht, Kontaktanschlüsse zu erzeugen, die eine größere Länge aufweisen. Die leitfähige Kontaktschicht kann derart strukturiert werden, daß in dem strukturierten Trennbereich eine Durchtrennung ausgebildet wird. So werden die Kontaktanschlüsse, die zu benachbarten elektronischen Elementen gehören, bei der Strukturierung getrennt voneinander ausgebildet.

Die maximale Tiefe der räumlichen Struktur der Trennbereiche kann entsprechend der gewünschten Enddicke der elektronischen Elemente gewählt werden. Die maximale Dicke der elektronischen Elemente ist dadurch festgelegt, daß beim Abtragen des Materials die leitfähigen Kontaktanschlüsse freigelegt werden. Durch geeignet angeordnete Verzögerungsschichten kann der Abtragvorgang auf der Rückseite der elektronischen Elemente und in den Trennbereichen unterschiedlich stark ausgeführt werden.

Zueinander benachbarte elektronische Elemente können in einer horizontalen Ebene des Halbleiterwafers versetzt zueinander angeordnet sein, und die einem elektronischen Element zugeordneten leitfähigen Kontaktanschlüsse können sich jeweils entlang des gesamten Querschnitts des strukturierten Trennbereiches erstrecken. Auf diese Weise können längere Kontaktanschlüsse erzeugt werden, ohne daß eine breitere oder tiefere bzw. höhere Struktur im Trennbereich ausgebildet werden muß.

Wenn in den Trennbereichen Vertiefungen eingebracht worden sind, können diese mit einem von den Kontaktanschlüssen verschiedenen Material, vorzugsweise einem Isolator, ausgefüllt werden, und die Vorderseite kann mit einer Schicht aus diesem Material versehen werden. Hierdurch wird die Vorderseite der elektronischen Elemente geschützt. Zudem werden die voneinander isolierten elektronischen Elemente im Waferverbund zusammengehalten, so daß eine Weiterbearbeitung der elektronischen Elemente im Verbund ermöglicht wird. Das Material kann auch auf die Rückseite des Halbleiterwafers bzw. der elektronischen Elemente aufgebracht werden, so daß das gesamte elektronische Element mit dem Material umgeben ist. Diese kann zur Isolation und zum Schutz der elektronischen Elemente dienen. Auf die Rückseite wird dieses Material erst aufgebracht, wenn das Material des Halbleiterwafers bereits auf die gewünschte Enddicke der elektronischen Elemente abgetragen worden ist. Das auf die Vorderseite aufgebrachte und in die Trennbereiche eingefüllte Material darf noch nicht vollständig durchtrennt sein, damit die elektronischen Elemente eines Halbleiterwafers zusammengehalten werden. Die Beschichtung von Vorder- und Rückseite des Wafers kann gleichzeitig erfolgen. Hierzu kann eine Spritzgußform verwendet werden, die so in den Vertiefungen und in den Trennbereichen angeordnet werden kann, daß die Bereiche nicht mit dem Material gefüllt werden. Dadurch wird verhindert, daß die Kontaktanschlüsse passiviert werden.

Vorteilhafterweise können die durch das auf der Vorderseite und in den Trennbereichen aufgebrachte Material zusammengehaltenen elektronischen Elemente eines Halbleiterwafers im Verbund getestet und abhängig von dem Testergebnis gekennzeichnet werden. Dabei wird die Kennzeichnung auf die elektronischen Elemente aufgebracht, die später aussortiert werden sollen.

Im folgenden wird die Erfindung anhand der Zeichnung näher erläutert.
Die Figuren 1 bis 3 zeigen einen Querschnitt durch gemäß dem erfindungsgemäßen Verfahren hergestellten elektronischen Elementen nach unterschiedlichen Verfahrensschritten,
die Figuren 4 und 5 einen Querschnitt durch gemäß einem anderen Ausführungsbeispiel des Verfahrens hergestellten elektronischen Elementen,
die Figur 6a eine Draufsicht auf elektronische Elemente in einem Halbleiterwafer,
die Figur 6b einen vergrößerten Ausschnitt aus der Figur 6a und
die Figuren 7 und 8 einen Querschnitt durch gemäß einem weiteren Ausführungsbeispiel des Verfahrens hergestellten elektronischen Elementen.

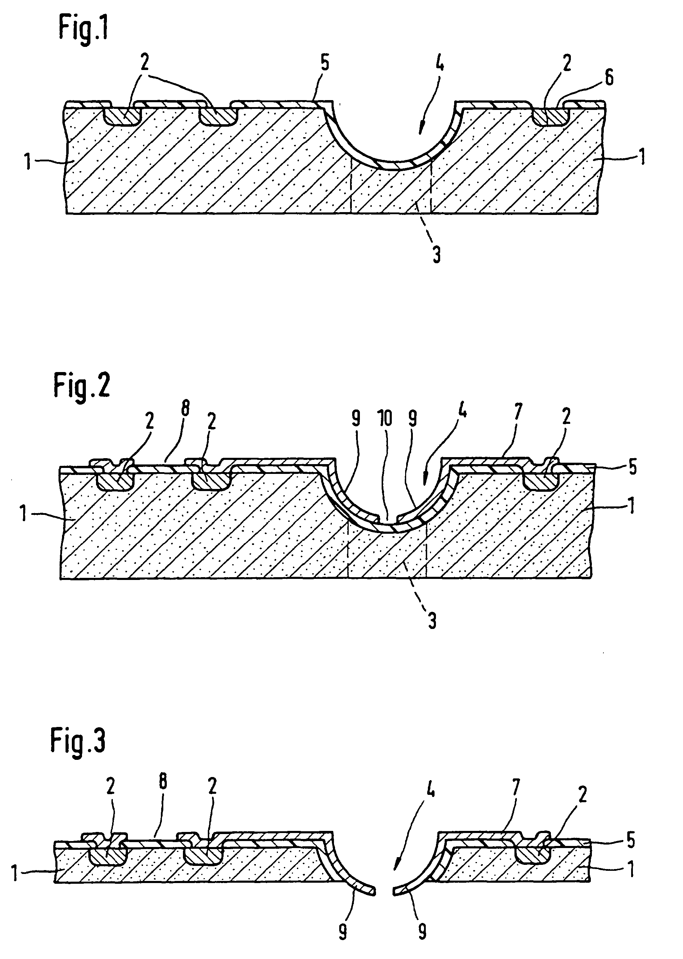

Fig. 1 zeigt einen Ausschnitt aus dem Querschnitt durch einen Halbleiterwafer. Es sind Ausschnitte von zwei aus dem Wafer herzustellenden elektronischen Elementen 1 gezeigt. Auf der Vorderseite des Halbleiterwafers sind aktive Bereiche 2 für die elektronischen Elemente 1 ausgebildet. Es sind Trennbereiche 3 zum Trennen der elektronischen Elemente 1 vorgesehen. In den Trennbereichen ist in Bezug auf eine Ebene durch die Vorderseite des Halbleiterwafers eine Vertiefung 4 ausgebildet. Auf der Vorderseite des Halbleiterwafers ist eine Isolatorschicht 5 aufgebracht, die Öffnungen 6 zum Kontaktieren der aktiven Bereiche 2 aufweist. Die Isolatorschicht 5 ist auch in der Vertiefung 4 des Trennbereichs 3 ausgebildet. Bei dem Halbleiterwafer handelt es sich hier um einen Siliziumwafer, die Isolatorschicht besteht aus Siliziumoxid oder aus Siliziumnitrid.

Gemäß Fig. 2 wird auf die Vorderseite des gemäß Fig. 1 ausgebildeten Halbleiterwafers eine elektrisch leitfähige Kontaktschicht 7 aufgebracht. Die Kontaktschicht 7 wird derart strukturiert, daß zwischen nicht miteinander zu kontaktierenden aktiven Bereichen 2 Durchbrechungen 8 ausgebildet werden, und Kontaktanschlüsse 9 erzeugt werden, die sich von der Vorderseite des Halbleiterwafers entlang des Querschnitts der Vertiefung 4 erstrecken. Im unteren Bereich der Vertiefung ist in der Kontaktschicht 7 eine Durchtrennung 10 ausgebildet, so daß die Kontaktanschlüsse 9 der benachbarten elektronischen Elemente 2 voneinander elektrisch getrennt sind. Die Kontaktschicht 7 kann aus verschiedenen, aufeinanderfolgenden Schichten bestehen.

Gemäß Fig. 3 wird von der Rückseite des Halbleiterwafers gemäß Fig. 2 ausgehend Material abgetragen. Dadurch werden die Kontaktanschlüsse 9 freigelegt, wobei die Kontaktanschlüsse 9 von zueinander benachbarten elektronischen Elementen 1 voneinander getrennt werden, und die Rückseite des Halbleiterwafers bzw. der elektronischen Elemente 1 abgedünnt wird. Nach dem Abdünnvorgang wird die jetzt freigelegte Schicht 5 im Trennbereich 3 in einem separaten Ätzvorgang entfernt, ohne daß die Rückseite der elektronischen Elemente 1 und die Kontaktschicht 7 wesentlich verändert wird. Das Abtragen des Materials des Halbleiterwafers erfolgt durch Ätzen, so daß die Kontaktanschlüsse 9 beim Freilegen nicht beschädigt werden. Die freigelgten Kontaktanschlüsse 9 können thermisch, chemisch bzw. mechanisch weiterbearbeitet werden. Sie können beispielsweise galvanisch verstärkt werden.

Die maximale Tiefe der Vertiefung 4 in dem Trennbereich 3 ist ensprechend der Enddicke der elektronischen Elemente 1 und der Länge der Kontaktanschlüsse 9 gewählt.

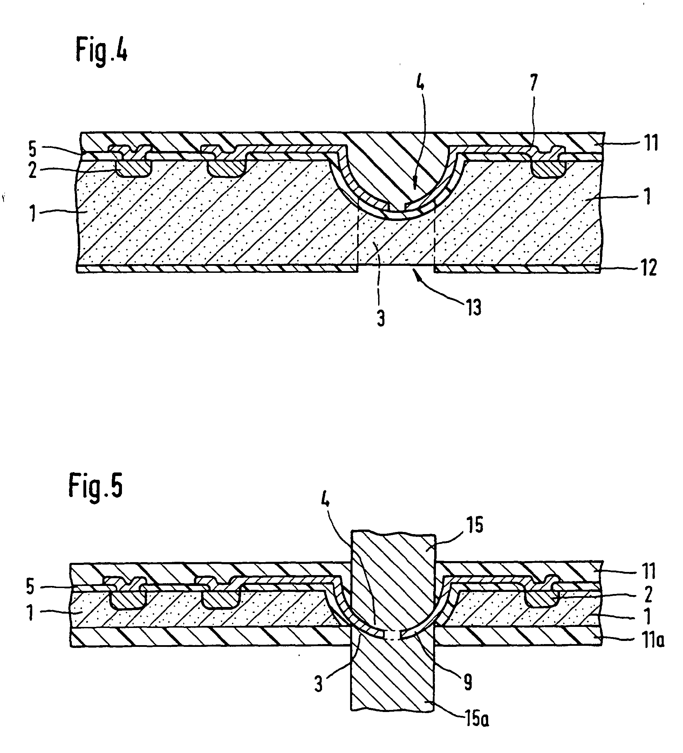

In Fig. 4 ist ein erfindungsgemäßes Ausführungsbeispiel des Verfahrens gezeigt, bei dem ausgehend von Fig. 2 auf die Vorderseite des Halbleiterwafers eine Schicht 11 aus einem von der Kontaktschicht 7 verschiedenen Material, welches vorzugsweise ein Isolator ist, aufgebracht wird. Mit dem Material der Schicht 11 wird auch die Vertiefung 4 ausgefüllt. Auf die Rückseite des Halbleiterwafers ist eine Verzögerungsschicht 12 aufgebracht, die in dem Trennbereich 3 eine Öffnung 13 aufweist. Dadurch erfolgt der Materialabtrag im Bereich der Verzögerungssschicht 12 langsamer als im Trennbereich 3, so daß eine vorgegebene Dicke der elektronischen Elemente 1 erhalten bleibt. Nachdem die Schicht 5 im Trennbereich 3 entfernt worden ist, werden die elektronischen Elemente 1 aufgrund der Durchtrennung 10 voneinander getrennt.

Fig. 5 zeigt elektronische Elemente 1 im Waferverbund. Auf ihrer Vorderseite ist die Schicht 11 und auf ihrer abgedünnten Rückseite eine Schicht 11a aufgebracht, welche aus dem gleichen Material wie die Schicht 11 besteht. In dem Trennbereich 3 und in der Vertiefung 4 zwischen den elektronischen Elementen 1 sind Spritzgußformen 15 und 15a angeordnet, die bewirken, daß die Kontaktanschlüsse 9 nicht von dem Material der Schichten 11 und 11a umhüllt werden. In den übrigen, nicht gezeigten Vertiefungen und Trennbereichen zwischen den weiteren elektronischen Elementen 1 des Halbleiterwafers sind entsprechende Spritzgußformen angeordnet.

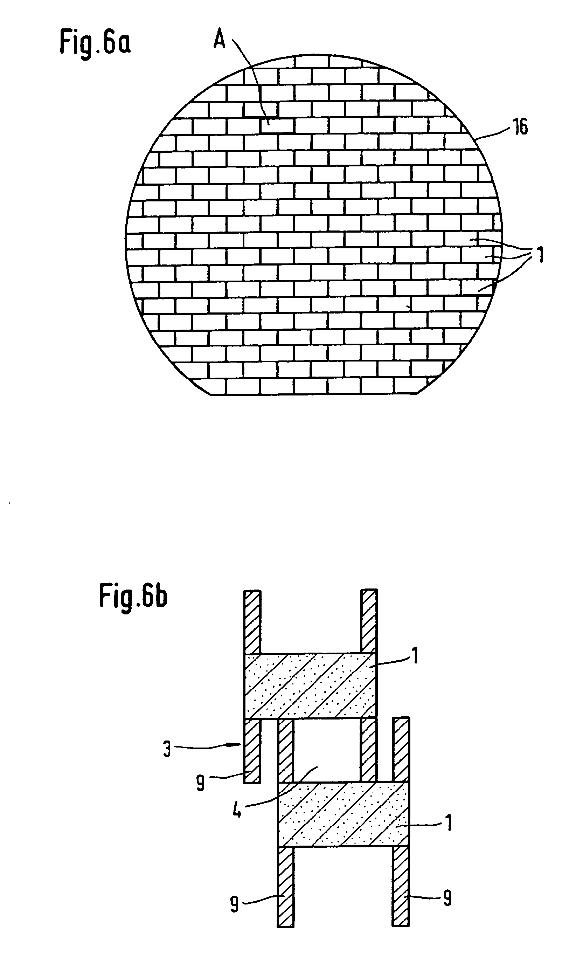

Fig. 6a zeigt eine Draufsicht auf einen Wafer 16, in dem die elektronischen Elemente 1 miteinander verbunden sind. In diesem Ausführungsbeispiel sind die elektronischen Elemente 1 reihenweise versetzt zueinander angeordnet. Dabei sind die Seiten der elektronischen Elemente 1, von denen die Kontaktanschlüsse 9 abstehen, parallel zueinander versetzt und zwar so, daß die Kontaktanschlüsse 9 von einander gegenüberliegenden Elementen einander nicht gegenüberliegen.

In Fig. 6b ist der Ausschnitt A der Figur 6a vergrößert gezeigt. Die Kontaktanschlüsse 9 eines elektronischen Elementes erstrecken sich in diesem Ausführungsbeispiel über den gesamten Querschnitt der Vertiefung 4 in den Trennbereichen 3. In diesem Ausführungsbeispiel ist keine Durchtrennung 10 in dem mittleren Bereich der Vertiefung 4 zwischen den Kontaktanschlüssen 9 ausgebildet. Die Kontaktanschlüsse 9 erstrecken sich vielmehr über nahezu den gesamten Querschnitt der Vertiefung 4. Auf diese Weise können erheblich längere Kontaktanschlüsse 9 ausgebildet werden. Die elektronischen Elemente 1 können in dem in der Figur 6a gezeigten Waferverbund getestet werden.

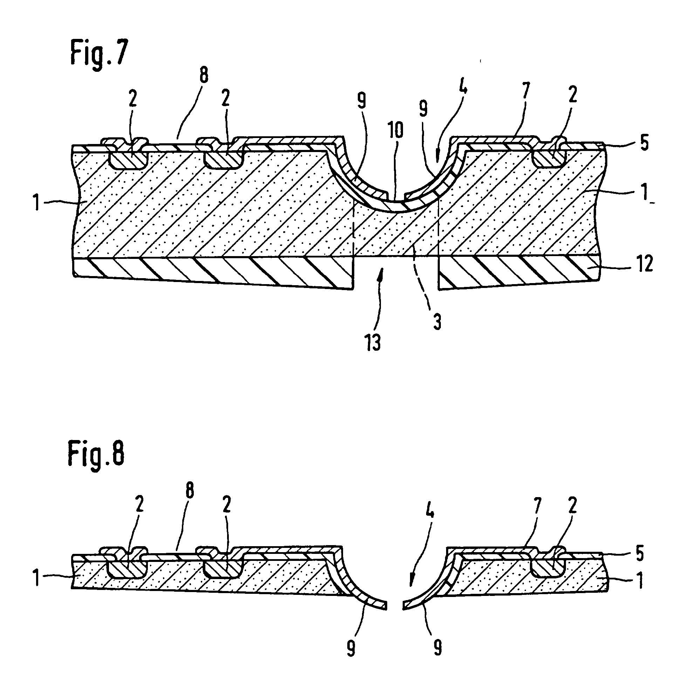

In dem in Figur 7 gezeigten Ausführungsbeispiel wird eine Verzögerungsschicht aufgebracht die derart ausgebildet ist, daß das Abtragen des Materials des Halbleiterwafers mit einer Abtragsrate erfolgt, die entlang des Waferquerschnitts bzw. des Querschnitts der elektronischen Elemente 1 einen Gradienten aufweist. Durch das gradientenartige Verzögern des Abtragens des Materials des Halbleiterwafers entstehen, wie in Fig. 8 gezeigt, elektronische Elemente 1, deren Rückseite gegenüber ihrer Vorderseite einen Neigungswinkel aufweisen. Diese elektronischen Elemente 1 sind besonders als Sensorelemente geeignet. Sie werden mit ihrer Rückseite auf eine ebene Montageplatte aufgesetzt, so daß ihre Vorderseite hinsichtlich der durch die Montageplatte aufgespannten Ebene geneigt ist. Es können aus einem Wafer elektronische Elemente 1 mit unterschiedlichen Neigungswinkeln zwischen der Rückseite und der Vorderseite der elektronischen Elemente 1 ausgebildet werden. Somit können auf einer ebenen Montageplatte Sensoren mit unterschiedlich geneigten Vorderseiten angebracht werden. Die Sensorfläche befindet sich auf der Vorderseite und wird in dem gezeigten Ausführungsbeispiel durch einen aktiven Bereich 2 gebildet. Wenn die Sensorelemente mit den Kontaktanschlüssen 9 auf einer Montageunterlage kontaktiert werden, ist die Vorderseite der Sensorelemente und damit die Sensorfläche für die Signalgewinnung leicht zugänglich.

## Patentansprüche

1. Verfahren zum Herstellen von elektronischen Elementen (1) aus einem Halbleiterwafer, auf dessen Vorderseite aktive Bereiche (2) für die elektronischen Elemente (1) ausgebildet sind, und welcher Trennbereiche (3) zum Trennen der elektronischen Elemente (1) aufweist, wobei die Trennbereiche in der Nähe der Vorderseite des Halbleiterwafers strukturiert sind, bei dem eine leitfähige Kontaktschicht (7) aufgebracht und derart strukturiert wird, daß sich leitfähige Kontaktanschlüsse (9) von der Vorderseite des Halbleiterwafers über wenigstens einen Teil des Querschnitts der strukturierten Trennbereiche (3) erstrecken, **dadurch gekennzeichnet, daß** die Kontaktanschlüsse (9) eines elektronischen Elements (1) so ausgebildet werden, daß sie sich höchstens bis zu dem jeweils gegenüberliegenden elektronischen Element (1) erstrecken, die Kontaktanschlüsse (9) durch Abtragen von Material des Halbleiterwafers von der Rückseite des Halbleiterwafers ausgehend, freigelegt werden, und mindestens bis in die Ebene der Unterseite des Halbleiterwafers, nach dem Abtragen von Material, ragen, wobei die einander gegenüberliegenden elektronischen Elemente sowie deren Kontaktanschlüsse (9) voneinander getrennt werden.

2. Verfahren nach einem der vorangehenden Ansprüche, **dadurch gekennzeichnet, daß** das Abtragen des Materials des Halbleiterwafers durch Ätzen erfolgt.

3. Verfahren nach einem der vorangehenden Ansprüche, **dadurch gekennzeichnet, daß** das Abtragen des Materials des Halbleiterwafers auf der Rückseite der mit mindestens einem Gradienten erfolgt, so daß die Rückseite der elektronischen Elemente (1) gegenüber ihrer Vorderseite geneigt ist.

4. Verfahren nach einem der vorangehenden Ansprüche, **dadurch gekennzeichnet, daß** die leitfähige Kontaktschicht (7) ein elektrisch-, thermisch- bzw. lichtleitendes Material umfaßt.

5. Verfahren nach einem der vorangehenden Ansprüche, **dadurch gekennzeichnet, daß** die leitfähige Kontaktschicht verschiedene, aufeinanderfolgende Schichten umfaßt.

6. Verfahren nach einem der vorangehenden Ansprüche, **dadurch gekennzeichnet, daß** die freigelegten Kontaktanschlüsse (9) thermisch, chemisch bzw. mechanisch bearbeitet werden.

7. Verfahren nach einem der vorangehenden Ansprüche, **dadurch gekennzeichnet, daß** die freigelegten Kontaktanschlüsse (9) verstärkt, insbesondere galvanisch verstärkt werden.

8. Verfahren nach einem der vorangehenden Ansprüche, **dadurch gekennzeichnet, daß** die freigelegten Kontaktanschlüsse (9) gebogen werden.

9. Verfahren nach einem der vorangehenden Ansprüche, **dadurch gekennzeichnet, daß** mittels der leitfähigen Kontaktschicht (7) die aktiven Bereiche (2) kontaktiert werden, wobei die Kontaktschicht (7) auf eine auf der Vorderseite des Halbleiterwafers ausgebildeten Isolatorschicht (5) mit Öffnungen (6) zum Kontaktieren der aktiven Bereiche (2) aufgebracht und derart strukturiert wird, daß zwischen nicht miteinander zu kontaktierenden Bereichen (2) jeweils eine Durchbrechung (8) ausgebildet wird.

10. Verfahren nach einem der vorangehenden Ansprüche, **dadurch gekennzeichnet, daß** die Trennbereiche (3) derart strukturiert werden, daß eine Vertiefung (4) entsteht.

11. Verfahren nach Anspruch 11, **dadurch gekennzeichnet, daß** die Trennbereiche derart strukturiert werden, daß in der Vertiefung wenigstens eine Erhöhung ausgebildet wird.

12. Verfahren nach einem der vorangehenden Ansprüche, **dadurch gekennzeichnet, daß** die maximale Tiefe der räumlichen Struktur der Trennbereiche (3) entsprechend der gewünschten Enddicke der elektronischen Elemente (1) gewählt ist.

13. Verfahren nach einem der vorangehenden Ansprüche, **dadurch gekennzeichnet, daß** benachbarte elektronische Elemente (1) in einer horizontalen Ebene des Halbleiterwafers versetzt zueinander angeordnet sind, und die einem elektronischen Element zugeordneten leitfähigen Kontaktanschlüsse (9) sich jeweils entlang des gesamten Querschnitts des strukturierten Trennbereichs (3) erstrecken.

14. Verfahren nach einem der Ansprüche 11 bis 14, **dadurch gekennzeichnet, daß** eine Schicht (11) aus einem von den Kontaktanschlüssen (9) verschiedenen Material, vorzugsweise einem Isolator, auf die Vorderseite des Halbleiterwafers aufgebracht wird und die Vertiefungen (4) mit dem Material ausgefüllt werden.

15. Verfahren nach Anspruch 15, **dadurch gekennzeichnet, daß** aus dem Material gleichzeitig eine Schicht (11) auf die Vorderseite außerhalb der Vertiefungen (4) und eine Schicht (11a) auf die Rückseite außerhalb der Trennbereiche (3) der elektronischen Elemente (1) aufgebracht werden.

16. Verfahren nach einem der Ansprüche 15 oder 16, **dadurch gekennzeichnet daß** die beschichteten elektronischen Elemente (1) im Verbund getestet und abhängig von dem Testergebnis **gekennzeichnet** werden.

## Claims

1. Process for producing electronic elements (1) from a semiconductor wafer, on the front side of which there are active regions (2) for the electronic elements (1), and which has separation regions (3) for separating the electronic elements (1), wherein the separation regions are structured close to the front side of the semiconductor wafer, in which a conductive contact layer (7) is applied and is structured in such a way that conductive terminals (9) extend from the front side of the semiconductor wafer over at least part of the cross section of the structured separation regions (3), **characterised in that** the contact terminals (9) of an electronic element (1) are designed in such a way that they extend at most to the respective opposite electronic element (1), the contact terminals (9) are exposed by removing material of the semiconductor wafer starting from the rear side of the semiconductor wafer and protrude at least into the plane of the underside of the semiconductor wafer after the removal of material, wherein the opposite electronic elements and their contact terminals (9) are separated from one another.

2. Process according to one of the preceding claims, **characterised in that** the removal of the material of the semiconductor wafer takes place by means of etching.

3. Process according to one of the preceding claims, **characterised in that** the removal of the material of the semiconductor wafer on the rear side takes place with at least one gradient, so that the rear side of the electronic elements (1) is inclined with respect to their front side.

4. Process according to one of the preceding claims, **characterised in that** the conductive contact layer (7) comprises an electrically conductive, thermally conductive or light-conductive material.

5. Process according to one of the preceding claims, **characterised in that** the conductive contact layer comprises different, successive layers.

6. Process according to one of the preceding claims, **characterised in that** the exposed contact terminals (9) are processed thermally, chemically and/or mechanically.

7. Process according to one of the preceding claims, **characterised in that** the exposed contact terminals (9) are reinforced, in particular by means of electroplating.

8. Process according to one of the preceding claims, **characterised in that** the exposed contact terminals (9) are bent.

9. Process according to one of the preceding claims, **characterised in that** the active regions (2) are contacted by means of the conductive contact layer (7), wherein the contact layer (7) is applied to an insulator layer (5) formed on the front side of the semiconductor wafer, said insulator layer having openings (6) for contacting the active regions (2), and said contact layer (7) is structured in such a way that an interruption (8) is formed in each case between regions (2) which are not to be contacted with one another.

10. Process according to one of the preceding claims, **characterised in that** the separation regions (3) are structured in such a way that a depression (4) is formed.

11. Process according to claim 11, **characterised in that** the separation regions are structured in such a way that at least one raised area is formed in the depression.

12. Process according to one of the preceding claims, **characterised in that** the maximum depth of the spatial structure of the separation regions (3) is selected according to the desired final thickness of the electronic elements (1).

13. Process according to one of the preceding claims, **characterised in that** adjacent electronic elements (1) are arranged offset with respect to one another in a horizontal plane of the semiconductor wafer, and the conductive contact terminals (9) assigned to an electronic element in each case extend along the entire cross section of the structured separation region (3).

14. Process according to one of claims 11 to 14, **characterised in that** a layer (11) of a material different from that of the contact terminals (9), preferably an insulator, is applied to the front side of the semiconductor wafer, and the depressions (4) are filled with the material.

15. Process according to claim 15, **characterised in that** a layer (11) on the front side outside the depressions (4) and a layer (11a) on the rear side outside the separation regions (3) of the electronic elements (1) are simultaneously applied from the material.

16. Process according to one of claims 15 or 16, **characterised in that** the coated electronic elements (1) are tested on the wafer and marked according to the test result.

## Revendications

1. Procédé de fabrication d'éléments électroniques (1) à partir d'une plaquette semi-conductrice sur la face avant de laquelle on forme des zones actives (2) pour les éléments électroniques (1) avec, pour séparer les éléments électroniques (1), des zones de séparation (3) structurées près de la face avant de la plaquette semi-conductrice, en déposant une couche de contact (7) conductrice et structurée de manière que des raccords de contact (9) conducteurs, partant de la face avant de la plaquette, s'étendent sur au moins une partie de la section des zones de séparation structurées (3),
**caractérisé en ce que**
les raccords de contact (9) d'un élément électronique (1) sont constitués de manière à s'étendre au plus jusqu'à l'élément électronique situé en face, on libère ces raccords (9) par enlèvement du matériau de la plaquette semi-conductrice sur la face arrière de celle-ci, qui après cet enlèvement, font saillie au moins jusque dans le plan de la face inférieure de la plaquette, les éléments électroniques situés en face l'un de l'autre ainsi que leurs raccords de contact (9) étant séparés l'un de l'autre.

2. Procédé selon la revendication 1,
**caractérisé en ce que**
l'enlèvement du matériau de la plaquette semi-conductrice est effectué par gravure.

3. Procédé selon la revendication 1 ou 2,
**caractérisé en ce que**
l'enlèvement du matériau de la plaquette semi-conductrice sur la face arrière, s'effectue au moins avec un gradient tel que la face arrière des éléments électroniques (1) est inclinée par rapport à la face avant.

4. Procédé selon une des revendications précédentes,
**caractérisé en ce que**
la couche de contact (7) conductrice comprend un matériau conducteur de l'électricité, de la chaleur ou de la lumière.

5. Procédé selon une des revendications précédentes,
**caractérisé en ce que**
la couche de contact conductrice comprend diverses couches se faisant suite.

6. Procédé selon une des revendications précédentes,
**caractérisé en ce que**
les raccords de contact (9) libérés sont soumis à un traitement thermique, chimique ou mécanique.

7. Procédé selon une des revendications précédentes,
**caractérisé en ce que**
les raccords de contact (9) libérés sont renforcés, notamment par galvanisation.

8. Procédé selon une des revendications précédentes,
**caractérisé en ce que**
les raccords de contact (9) sont recourbés.

9. Procédé selon une des revendications précédentes,
**caractérisé en ce que**
par l'intermédiaire de la couche (7) conductrice, les zones actives (2) sont mises en contact, en déposant cette couche (7) sur une couche d'isolation (5) réalisée sur la face avant de la plaquette semi-conductrice avec des ouvertures (6) pour assurer le contact des zones actives (2), et en la structurant pour créer une interruption (8) entre des zones (2) qui ne doivent pas être en contact.

10. Procédé selon une des revendications précédentes,
**caractérisé en ce que**
les zones de séparation (3) sont structurées pour présenter une cavité (4).

11. Procédé selon la revendication 10,
**caractérisé en ce que**
la cavité dans les zones de séparation présente au moins une saillie.

12. Procédé selon une des revendications précédentes,
**caractérisé en ce que**
la profondeur maximale de la structure spatiale des zones de séparation (3) est choisie en correspondance avec l'épaisseur finale désirée pour les éléments électroniques (1).

13. Procédé selon une des revendications précédentes,
**caractérisé en ce que**
des éléments électroniques (1) voisins, dans un plan horizontal de la plaquette semi-conductrice, sont décalés l'un par rapport à l'autre, et les raccords de contact (9) conducteurs associés à un élément électronique s'étendent le long de toute la section de la zone de séparation (3) structurée.

14. Procédé selon une des revendications 11 à 13,
**caractérisé en ce qu'**
une couche (11) en un matériau différent à celui des raccords de contact (9), de préférence un matériau isolant, est déposée sur la face avant de la plaquette semi-conductrice et les cavités (4) sont remplies de ce matériau.

15. Procédé selon la revendication 14,
**caractérisé en ce qu'**
en même temps une couche (11) du matériau est déposée sur la face avant en dehors des cavités (4), et une couche (11a) de ce matériau est déposée sur la face arrière en dehors des zones de séparation (3) des éléments électroniques (1).

16. Procédé selon la revendication 14 ou 15,
**caractérisé en ce que**
les éléments électroniques (1) garnis sont contrôlés dans le composite et spécifiés en fonction du résultat de l'examen.
